# EUROPEAN PATENT SPECIFICATION

(11) **EP 0 784 101 B1**
(45) Date of publication and mention of the grant of the patent: **18.08.1999**
(21) Application number: 96308968.5
(22) Date of filing: 10.12.1996
(51) Int. Cl.: C23C 14/06

(54) **Structure formed with transparent protective film and method for production thereof**
Artikel mit transparenten Schutzfilm und Verfahren zu seiner Herstellung
Pièce à film transparent protecteur et procédé de sa fabrication

(30) Priority: 14.12.1995 JP 34793595
(43) Date of publication of application: 16.07.1997
(73) Proprietor: ORIENT WATCH CO., LTD., Tokyo (JP)
(72) Inventor: Nakamura, Yutaka, Chiyoda-ku, Tokyo (JP)
(74) Representative: Cooper, John

(56) References cited:
- EP-A- 0 430 874
- JOURNAL OF NON-CRYSTALLINE SOLIDS, vol. 135, no. 2 / 03, 1 November 1991, pages 227-235, XP000258397 HANADA T ET AL: "PREPARATION AND PHYSICAL PROPERTIES OF RF-SPUTTERED AMORPHOUS FILMS IN THE AL2O3-AIN SYSTEM"

## Description

### BACKGROUND OF THE INVENTION

### 1. Field of the Invention

The present invention relates to a structure which is formed with a transparent protective film made of aluminum oxynitride and a method for production of the structure.

### 2. Description of the Related Art

Articles made of noble or precious metal, for example, known decorative articles so far manufactured such as wrist watch cases, wrist watch bands or spectacle frames have conventionally been made of silver or silver alloy or made of a copper substrate plated with silver. However, since silver is to be easily susceptible to corrosion because silver is easily reacted with sulfur dioxide, hydrogen sulfide or the like present in the atmosphere to form sulfide, the precious metal article coated thereon with silver has had a problem that the silver changes its color to dark brown in a relatively short period. The similar problem has also occurred even for gold, platinum and copper.

Turning again to silver, for the purpose of avoiding the aforementioned problem, there has been suggested such a method that a transparent protective film made of aluminum oxide (Al₂O₃) or aluminum nitride (AlN) is formed on an original precious metal article coated thereon with silver to thereby obtain a final precious metal article (refer to Japanese Patent Laid-Open Publication No. 180071/1987).

The transparent protective film of aluminum oxide, however, is disadvantageous in that the film cannot act sufficiently as a protective film because the film is poor in its adhesion to the silver layer as a backing or underlying layer. In order to eliminate this disadvantage to able to put the transparent protective film in practical use, it has been necessary to apply an undercoat on the silver surface.

Meanwhile, since the transparent protective film of aluminum nitride is low in its optical reflectance, the film has had a problem that the color tone (shade and gloss or luster) inherent in silver is apparently lost.

### SUMMARY OF THE INVENTION

In view of the above problems, it is therefore an object of the present invention to prevent color change of the precious metal surface or precious metal alloy surface of a structure caused by sulfide gas for example hydrogen sulfide gas, sulfur dioxide, sulfur monoxide and the like.

Another object of the present invention is to provide a structure formed with a transparent protective film which has a good adhesion to a precious metal surface or a precious metal alloy surface and a good transparency while avoiding deterioration of the color tone of its underlying layer.

In the present invention, the term "structure" refers to not only precious metal decorative articles but also to utility articles formed thereon with precious metal or precious metal alloy and various types of other members.

In accordance with an aspect of the present invention, there is provided a structure formed with a transparent protective film, wherein the transparent protective film made of aluminum oxy/nitride (AlNO) is formed directly on a surface of silver, or on a surface of precious metal alloy containing silver, or on a surface of a structure plated with silver.

Since the transparent protective film made of aluminum oxynitride is high in corrosion resistance, the color change of its underlying layer, e.g., the silver or silver-alloy layer can be prevented. Further, since the transparent protective film is excellent in the adhesion to the underlying layer, the film can be used as a protective film while eliminating the need for providing any undercoat on the underlying layer, additionally making the most of the color tone of the underlying layer.

In accordance with another aspect of the present invention, there is provided a method for production of a structure formed with a transparent protective film, wherein the transparent protective film made of aluminum oxynitride is formed by a physical vapor phase growth process directly on a surface of silver, or on a surface of precious metal alloy containing silver, or on a surface of a structure plated with silver.

In the present invention, a physical vapor phase growth process is employed as a method for forming the transparent protective film, so that the transparent protective film of aluminum oxynitride can be positively formed on the surface of the aforementioned structure by making full use of the transparency of the film and the good adhesion thereof to the underlying layer.

The above physical vapor phase growth process is, for example, an ion plating process, a sputtering process, a vacuum evaporation process or the like.

### BRIEF DESCRIPTION OF THE DRAWINGS

The above and other objects, features and advantages of the present invention will become apparent from the following detailed description when taken with the accompanying drawing in which:

The drawing is a graph showing a relationship between reflectance and color tone of various types of transparent protective films as the results of Example 1 and Comparative Examples 1 to 3.

### DESCRIPTION OF THE PREFERRED EMBODIMENTS

The present invention will be detailed in connection with Examples.

### Example 1 And Comparative Examples 1 to 3

### (Formation of Transparent Protective Film)

A Ni film having a thickness of 3µm was plated on a test plate of BS blank (brass) having a thickness of 0.5mm, a width of about 25mm and a length of about 70mm.

A plurality of substrate were prepared by plating the plated surface of the test plate with a 1µm-thick silver layer. Formed on the individual silver-plated surfaces of the substrates are transparent protective films made of AlNO, Al₂O₃ and AlN respectively. More specifically, the substrate is formed with an AlNO film in Example 1, the substrate is formed with an Al₂O₃ film in Comparative Example 1, the substrate is formed with an AlN film in Comparative Example 2, and the substrate of controll is not formed with any transparent protective film in Comparative Example 3. In the respective Examples, the transparent protective film was set to be 0.1µm.

In Example 1, more in detail, the air within a deposition apparatus was evacuated therefrom until the pressure in the apparatus becomes 1.3 x 10⁻² Pa (1 x 10⁻⁴ Torr) or less, and then an Ar gas was introduced into the deposition apparatus until the pressure (which always refers to the pressure within the deposition apparatus, hereinafter) becomes 2.7 x 10⁻² Pa (2 x 10⁻⁴ Torr). Subsequently, an N₂ gas was supplied into the deposition apparatus as a reaction gas until the pressure becomes 4.8 x 10⁻² Pa (3.6 x 10⁻⁴ Torr), and further an O₂ gas was supplied into the deposition apparatus as a reaction gas until the pressure becomes 5.1 x 10⁻² Pa (3.8 x 10⁻⁴ Torr) to thereby form a transparent protective film of AlNO.

In the Comparative Example 1, setting was conducted in substantially the same manner as in the Example 1, except that only the O₂ gas was introduced as the reaction gas into the deposition apparatus until the pressure becomes 4.8 x 10⁻² Pa (3.6 x 10⁻⁴ Torr), thus forming a transparent protective film of Al₂O₃. In the Comparative Example 2, setting was conducted in substantially the same manner as in the Example 1, except that only the N₂ gas was introduced as the reaction gas into the deposition apparatus until the pressure becomes 4.8 x 10⁻² Pa (3.6 x 10⁻⁴ Torr), thus forming a transparent protective film of AlN.

In the Example 1 and Comparative Examples 1 and 2, an employed source of generating an Al component in the transparent protective film was of such a type as to use an electron-gun type evaporation source to evaporate metal aluminum. In this case, a film formation controller (trade name: XTC (INFICON)) of a crystal oscillator type was employed to control the electron gun to adjust the film forming rate and thickness of the AlNO film and so on.

### (Evaluation of Transparent Protective Films)

### (1) Adhesion of transparent protective film to silver surface (Peel resistance)

The substrates having the transparent protective films formed in such manners as mentioned above were bent at right angle and then examined as to the presence or absence of the peeled transparent protective films, which examination results were:

| | |
|---|---|
| Example 1 (AlNO film) | without peel |
| Comparative Example 1 (Al₂O₃ film) | with peel |
| Comparative Example 2 (AlN film) | without peel |

### (2) Corrosion resistance of transparent protective film to sulfide gas

The substrates in the Example 1 and Comparative Examples were placed and arranged in a desiccator in place, a test cup or beaker containing 200ml of aqueous solution containing 20wt% of ammonium sulfide was placed into the desiccator, and then was left to stand (which time will be referred to as the shelf time, hereinafter) for 60 minutes at room temperature as it is, during which a tester visually observed the color changing state of the respective substrates from outside of the desiccator.

The tester failed to recognize any color change in the substrates even after passage of the shelf time of 60 minutes in the Example 1 and Comparative Examples 1 and 2, whereas, he was able to recognize the start of a color change merely after passage of the shelf time of about 1 minute in the Comparative Example 3.

### (3) Color tone of substrates

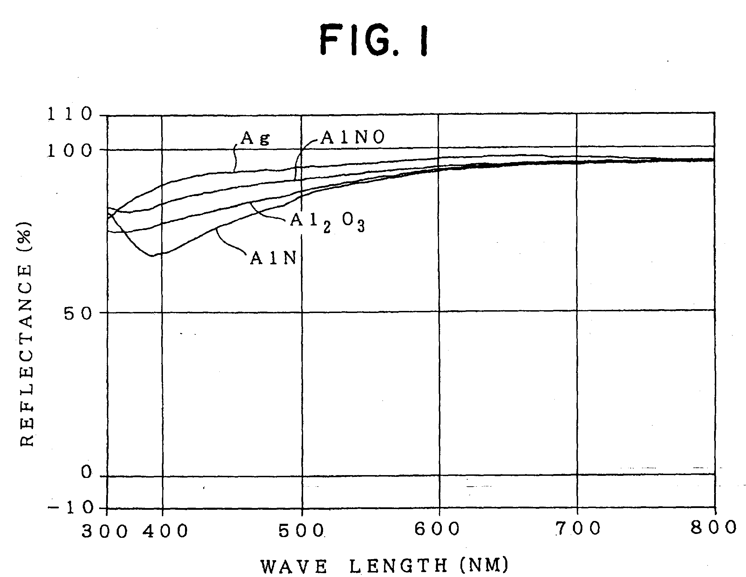

Observation results of the color tone of the respective substrates through their transparent protective films were as shown below in Table 1 based on the color specification standard (JIS Z8729-1980) of L*, a* and b*. This L*, a*, b* color specification data were prepared with use of reflectance spectral properties, i.e., reflectance measurement results (refer to Fig. 1) based on an integrating sphere system at a viewing angle of 2 degrees with use of a D65 light source.

**Table 1**

| | Transparent Protective Film | L* | a* | b* |
|---|---|---|---|---|
| Exam. 1 | ALNO film | 97.17 | 0.15 | 3.22 |
| Com. Exam. 1 | Al₂O₃ film | 96.38 | 0.04 | 5.80 |
| Com. Exam. 2 | ALN film | 96.01 | -0.82 | 8.69 |
| Com. Exam. 3 | None | 98.32 | 0.24 | 1.96 |

It will be clear from Table 1 that, in comparison between the AlNO film, Al₂O₃ film and AlN film, the color tone (more precisely, the tone of the silver surface observed through the transparent protective film) of the AlNO film was the closest to that of the non-processed silver surface. As a result, among these films, the AlNO film is the most excellent in transparency.

### (4) Light exposure durability of transparent protective film

The substrate of the Example and the substrate 1 of the Comparative Example 3 were put in a container of frosted glass in a side-by-side positional relation, and then the container was left to stand for 8 months near a window pane of a north-faced room into which a sufficient quantity of sunlight pours. As a result of the light exposure, the substrate of the Example 1 underwent no color change even after passage of 8 months of light exposure, while a color change was observed for the substrate of the Comparative Example 3 not provided with the transparent protective film.

As has been explained in the foregoing, in accordance with the present invention, the use of the aluminum oxynitride as the transparent protective film enables prevention of the color change caused by corrosion occurring on the surfaces of silver or silver-alloy.

Since the transparent protective film of the present invention has a good adhesion to a silver surface or silver-alloy surface or to a precious-metal-alloy surface containing silver, there can be formed a transparent protective film which is highly resistive to peel without any undercoat therebetween. In addition, the transparent protective film of the present invention has a good transparency, the film will not deteriorate the color tone of its underlying layer.

Therefore, in accordance with the present invention there can be manufactured a silver decorative article which is advantageously high in durability and quality.

## Claims

1. A structure formed with a transparent protective film, wherein said transparent protective film made of aluminium oxynitride (AlNO) is formed directly on a surface of silver, or on a surface of precious metal alloy containing silver, or on a surface of a structure plated with silver.

2. A method for fabricating a structure formed with a transparent protective film, wherein said transparent protective film made of aluminium oxynitride (AlNO) is formed by a physical vapour phase growth process directly on a surface of silver, or on a surface of precious metal alloy containing silver, or on a surface of a structure plated with silver.

## Revendications

1. Une structure formée d'un film protecteur transparent, dans laquelle ledit film protecteur transparent réalisé en oxynitrure d'aluminium (AlNO) est formé directement sur une surface en argent, ou sur une surface en alliage de métaux précieux contenant de l'argent, ou sur une surface d'une structure plaquée d'argent.

2. Un procédé de fabrication d'une structure d'un film protecteur transparent, dans lequel ledit film protecteur transparent réalisé en oxynitrure d'aluminium (AlNO) est formé par un processus physique de croissance en phase vapeur directement sur une surface en argent, ou sur une surface en alliage de métaux précieux contenant de l'argent, ou sur une surface d'une structure plaquée d'argent.

## Patentansprüche

1. Eine Artikel, die mit einem transparenten Schutzfilm gebildet wird, wobei der Schutzfilm aus Aluminiumoxynitrid (AlNO) besteht und direkt auf einer Silberoberfläche, oder auf einer Oberfläche einer Silber enthaltenden Edelmetallegierung, oder auf einer Oberfläche einer mit Silber bedeckten Struktur gebildet wird.

2. Ein Verfahren zur Herstellung einer mit einem transparenten Schutzfilm gebildeten Struktur, wobei der Schutzfilm aus Aluminiumoxynitrid (AlNO) besteht und mittels eines physischen Dampfphasenwachstumverfahrens direkt auf einer Silberoberfläche, oder auf einer Oberfläche einer Silber enthaltenden Edelmetallegierung, oder auf einer Oberfläche einer mit Silber bedeckten Struktur gebildet wird.
